# EUROPEAN PATENT APPLICATION

(11) **EP 3 267 125 A1**
(43) Date of publication of application: **10.01.2018**
(21) Application number: 15883699.9
(22) Date of filing: 04.03.2015
(51) Int. Cl.: F24J 2/00, H01L 31/054

(54) **SURFACE SOLAR SYSTEM**

(71) Applicant: Bolymedia Holdings Co. Ltd., Santa Clara, California 95051 (US)
(72) Inventor: HU, Xiaoping, Shenzhen Guangdong 518055 (CN)
(74) Representative: Manitz Finsterwald Patentanwälte PartmbB
(86) International application number: PCT/CN2015/073626
(87) International publication number: WO 2016/138642

(57) **Abstract**

A surface solar system, comprising a condensing clad plate (p1), a photovoltaic plate (p2) and a supporting component (p3), wherein the condensing clad plate is formed by splicing condensing modules in accordance with pre-set patterns. Each of the condensing modules comprises a condensing lens and a base, the condensing lens comprising at least one tooth surface, one of adjacent surfaces of the condensing lens and the base is a reflecting surface, and the reflecting surface is provided below the tooth surface along an incident surface of sunlight. The supporting component supports the photovoltaic plate above the condensing clad plate and is substantially located at a condensing position of the condensing clad plate. Since the condensing clad plate is formed by splicing a plurality of reflective condensing modules, the solar system is easy to install on a large area, and the reflecting surfaces are located inside the condensing modules, thereby being unlikely to damage and having better durability.

## Description

### Field of the Invention

The present invention relates to the technical field of clean energy, in particular to a surface solar system for using solar energy.

### Background of the Invention

With the increasing emphasis on environmental protection, solar energy systems have been used more and more widely. Common solar energy systems at present are installed on roofs or on road surfaces, such as solar water heating systems based on photothermal conversion and solar power generation systems based on photo-electric conversion.

In these common solar energy systems, their energy conversion devices, such as solar vacuum tubes or photovoltaic panels, typically face sunlight directly and the areas of their own working surfaces are the maximum areas they can receive sunlight, and thus energy collected by the conventional solar system is very limited, and the larger a photovoltaic plate, the higher the cost.

In order to improve the ability to collect solar energy, there has been a concentrated solar system. For example, Chinese patent application, with publication No. CN101640502A, discloses "Method for Assembling Condenser Photoelectrical Solar Cell Array" where sunlight is converged on a photovoltaic panel through a lens so that the photovoltaic panel with a smaller area can obtain sunlight converged from the lens with a larger area.

However, the use of existing condensing lenses is limited by a lot of installation conditions, resulting in low cost performance. In order to make better use of limited space and reduce costs, it is still desirable to develop a solar system which can be used on a large area and is easy to install and maintain.

### Summary of the Invention

The present invention provides a surface solar system, comprising a condensing clad plate, a photovoltaic plate and a supporting component, wherein the condensing clad plate is formed by splicing condensing modules in accordance with pre-set patterns. Each of the condensing modules comprises a condensing lens and a base for supporting the condensing lens, the condensing lens comprising at least one tooth surface, one of adjacent surfaces of the condensing lens and the base is a reflecting surface, and the reflecting surface is provided below the tooth surface along an incident surface of sunlight. The photovoltaic plate has at least one photosurface which is capable of absorbing sunlight and the at least one photosurface is arranged to face the condensing clad plate. The supporting component is used for supporting the photovoltaic plate above the condensing clad plate and is substantially located at a condensing position of the condensing clad plate.

According to the surface solar system of the present invention, since the condensing clad plate is formed by splicing a plurality of reflective condensing modules, the solar system is easy to install on a large area; the reflecting surfaces are located inside the condensing modules, thereby being unlikely to be damaged and having better durability; the photovoltaic plate is supported above the condensing clad plate, thereby being unlikely to be damaged and being convenient to install, maintain and renew. Since the cost of the condensing clad plate is far lower than that of the photovoltaic plate, the present invention increases the convergence area with a large-area low-cost condensing clad plate so that the area of the high-cost photovoltaic plate can be reduced, thereby not only improving the utilization efficiency of solar energy but also greatly reducing the cost of the solar system.

Specific examples according to the present invention are described in detail below with reference to the accompanying drawings.

### Brief Description of the Drawings

FIG. 1 is a schematic diagram of the arrangement of a plurality of Fresnel units on a condensing clad plate in the present invention;
FIG. 2 is a schematic diagram of a Fresnel reflection lens in the present invention;
FIG. 3 is a schematic diagram of structures in several examples of condensing modules in the present invention;
FIG. 4 is a schematic diagram of the basic structure of a surface solar system according to the present invention;
FIG. 5 is a schematic diagram of a surface solar system according to Embodiment 1;
FIG. 6 is a schematic diagram of a surface solar system according to Embodiment 2; and
FIG. 7 is a schematic diagram of a surface solar system according to Embodiment 3.

### Detailed Description of the Preferred Embodiments

Fresnel lenses are used in the solar system according to the present invention, and for the sake of understanding, the related concepts are described below.

The Fresnel lens is a thin lens. By dividing the continuous original curved surface of an ordinary lens into several segments, after the thickness of each curved segment is reduced, all the curved surface segments are put on the same plane or the same substantially smooth curved surface to form the Fresnel lens. This discontinuous refraction surface evolved from the original curved surface can be called a Fresnel refraction surface, which is generally step-shaped or tooth-shaped. In theory, the Fresnel refraction surface has an optical performance approximate to that of the corresponding original curved surface, but its thickness is greatly reduced. The Fresnel refraction surface produced by one original curved surface (or a part of one original curved surface) can be called a Fresnel unit.

Conventional original curved surfaces for generating Fresnel refraction surfaces are generally curved surfaces that are symmetrical about the optical axis, such as spherical surfaces and rotating curved surfaces (such as rotating paraboloids). The focuses of the conventional original curved surfaces are at one point and therefore they can be called "concurrent planes". In the present invention, the original curved surfaces may be any form of coaxial surfaces, which may be specifically arranged as needed by the application. The term "coaxial surfaces" refers to curved surfaces whose focuses are on the same line (not necessarily at the same point), which may be referred to as a "coaxial line". The conventional concurrent planes can be regarded as a special case when the coaxial line of the coaxial surfaces is degraded to a point. Due to use of original surfaces which are coaxial but not concurrent, a sensing element configured at the focusing location may be expanded from a smaller area (corresponding to the focal point) to a long strip (corresponding to a coaxial line consisting of focuses), thereby enhancing the capability of signal collection and helping solve the problem of local overheating, without significantly increasing the cost. Typical coaxial surfaces include rotating curved surfaces (including rotating curved surfaces of the second order or a higher order), column surfaces, tapered surfaces, and the like. The column surfaces can be called constant-section coaxial surfaces, and their sections obtained through cutting off these curved surfaces at any point along a direction perpendicular to the coaxial line are consistent in shape and size. A cylindrical surface is a special case of column surfaces. The cross sections of tapered surfaces along the coaxial line are similar in shape but different in size, and a conical surface is a special case of tapered surfaces.

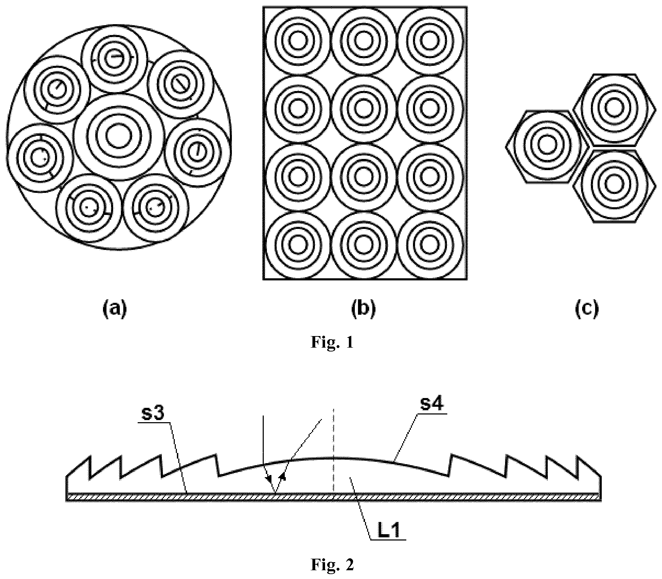

A macroscopic refraction plane consisting of one or more Fresnel units may be referred to as a tooth surface, and a substantially smooth or flat surface opposite thereto may be referred to as a back surface. A tooth surface containing only one Fresnel unit can be referred to as a "simple Fresnel refraction surface" and a tooth surface containing two or more Fresnel units is referred to as a "composite Fresnel refraction surface". In general, the basic parameters (for example, area, focal length, the shape of the corresponding original curved surface, the number of concentric rings used to split the original curved surface, etc.) of the Fresnel units on the composite Fresnel refraction surface can be flexibly configured and may be completely identical, partially identical or completely different. In one embodiment, all Fresnel units on the composite Fresnel refraction surface have their own optical centers, but their focuses fall at the same point, or on a straight line, or in a limited area. This can be achieved by spatial arrangement of each Fresnel unit constituting the composite Fresnel refraction surface. FIG. 1 shows the arrangement of Fresnel units of several typical Fresnel refraction surfaces, where FIG. 1 (a) shows a circularly symmetrical arrangement which is presented as a concentric circle pattern, FIG. 1 (b) shows an arrangement of a determinant which is presented as a square array pattern, and FIG. 1 (c) is a honeycomb arrangement which is presented as a honeycomb pattern. It may be contemplated that these Fresnel units are arranged on a macroscopic curved surface, such as a plane, a quadratic surface (including a spherical surface, an ellipsoid, a cylindrical surface, a parabolic cylinder surface, a hyperbolic cylinder surface), a high-order polynomial surface (a general implementation way of an aspheric surface), and a fold surface and a stair-shaped surface formed by jointing multiple planes, etc.

In general, the tooth surface and the back face can be flexibly combined to form different types of elements. For example, a Fresnel lens with a tooth surface and a back surface may be referred to as a "single-sided Fresnel lens". Further, if the tooth surface is a "simple Fresnel refraction surface", then the lens is a "single-sided simple Fresnel lens"; if the tooth surface is a "composite Fresnel refraction surface", then the lens is a "single-sided composite Fresnel lens". A Fresnel lens with both sides being tooth surfaces can be called a "double-sided Fresnel lens", and according to the type of the tooth surfaces, it could also be further divided into a "double-sided simple Fresnel lens" and a "double-sided composite Fresnel lens". If one tooth surface of a double-sided Fresnel lens is a simple Fresnel refraction surface and the other tooth surface is a composite Fresnel refraction surface, it can be referred to as a "double-sided hybrid Fresnel lens". In addition, as a variant, for a double-sided Fresnel lens, if one of the tooth surfaces is a "simple Fresnel refraction surface", this tooth surface may be replaced by a conventional convex lens surface or concave lens surface.

In the present invention, the condensing clad plate is formed by splicing condensing modules in accordance with a pre-set pattern, for example, the pattern shown in FIG. 1; each of the condensing modules comprises a tooth surface and a reflecting surface; the entire tooth surface of the spliced condensing clad plate may be a "composite Fresnel refraction surface", and each of the condensing modules contains a part of the refraction surface. For example, in one embodiment, each of the condensing modules comprises a simple Fresnel unit generated from a single original curved surface, which reduces the difficulty in making the condensing modules and facilitates large-area installation. In another embodiment, each of the condensing modules may comprise a composite Fresnel refraction surface and then the condensing modules are spliced together into a tooth surface with a larger area. In yet another embodiment, each of the condensing modules comprises only one Fresnel unit and the Fresnel unit is derived from a portion of a single original surface, and the plurality of condensing modules are spliced to obtain a tooth surface corresponding to the complete original curved surface. The pattern of the entire tooth surface of the condensing clad plate, the shape of a macroscopic curved surface, and the division mode of the condensing modules can be designed according to the desired optical parameters, for example, according to the desired focal length, coverage area, and the like.

The reflecting surface in each of the condensing modules may be planar reflecting surface or a curved reflecting surface, such as a concave or convex reflecting surface, and may also be a tooth-shaped reflecting surface, and the reflecting surface is provided below the tooth surface along an incident surface of sunlight. The combination of the tooth surface and the reflecting surface can be equivalently regarded as a Fresnel reflection lens (referred to as a lens having a reflection coating on one side). In FIG. 2, the element L1 has a reflecting surface s3 and a Fresnel refraction surface s4, and light is refracted into the lens from the refraction surface and then reflected by the reflecting surface, and refracted again out of the element through the refraction surface. Due to the reflection, an incident light path passes through a physical refraction interface s4 twice, and the physical interface is actually equivalent to two tooth surfaces, so the convergence effect of the system will be enhanced advantageously by arranging a reflecting surface.

In a particular implementation, each of the condensing modules may comprise two parts, i.e., a condensing lens and a base supporting the condensing lens. The condensing lens comprises at least one tooth surface, one of the adjacent surfaces of the condensing lens and the base is a reflecting surface. In other words, the reflecting surface and the tooth surface may be provided on the same element, for example, by providing a reflective coating on the back surface of a Fresnel lens; the reflecting surface and the tooth surface may also be provided on different elements, for example, a reflector or a reflective coating is provided on the surface, facing the condensing lens, of the base.

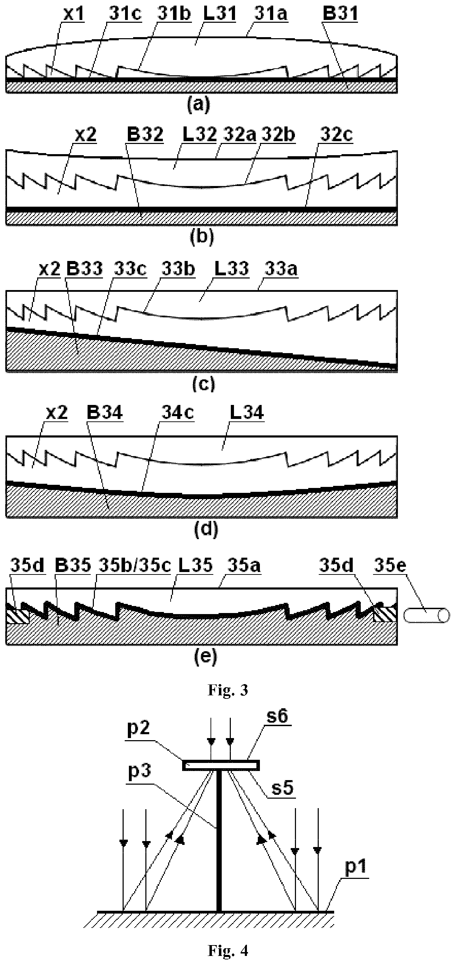

As an example, the following describes the structures of several condensing modules:
Referring to FIG. 3 (a), presented is a simple condensing module, comprising a condensing lens L31 and a base B31. The condensing lens has two condensing refraction surfaces, a convex surface 31a (as a back surface) and a tooth surface 31b. The upper surface 31c of the base has a reflective coating to act as a reflecting surface. With the tooth surface facing downward, the condensing lens is placed directly on the reflective coating of the base, and there is a gap x1 between the condensing lens and the base. The condensing module in this example has a simple structure and can be implemented with low cost. The condensing lens has the tooth surface facing downward, which can effectively protect the tooth surface and avoid the accumulation of dust and maintain its optical performance. The condensing lens has two condensing refraction surfaces, which achieves a better condensing effect and can reduce the comprehensive focal length of the system. However, due to the gap between the condensing lens and the base, the condensing module in this example should not be under pressure, and is more suitable for installation on a roof and other locations. In other embodiments, the condensing lens may also be arranged in such a manner that the tooth surface faces upward and the back surface comes into tight fit with the upper surface of the base, and the reflecting surface may be provided on the back surface of the condensing lens or the upper surface of the base, with reference to FIG. 2
Referring to FIG. 3 (b), presented is a filled-type condensing module, comprising a condensing lens L32 and a base B32. The condensing lens has two refraction surfaces, a concave surface 32a (as a back surface) and a tooth surface 32b. The upper surface 32c of the base has a reflective coating to act as a reflecting surface. The condensing lens has the tooth face facing downward but not coming into contact with the base, and there is a large gap x2 between the condensing lens and the base and the gap x2 is filled with a transparent filler such as compressed gas or transparent liquid (e.g., water). In this example, the condensing module has good compression resistance and durability, can be used for ground laying, such as sidewalks, stadium auditorium, balcony floor, etc .; the convex surface on the upper surface of the condensing lens may be designed initially, and may also be formed due to bending deformation after long-term use under a pressure, but the tooth surface and the reflecting surface are both protected within the module and therefore are unlikely to be damaged under pressure.

Referring to FIG. 3 (c), presented is another filled-type condensing module, comprising a condensing lens L33 and a base B33. This embodiment is similar to FIG. 3 (b), except that the back surface 33a of the condensing lens is a plane, and only the tooth surface 33b is a condensing refraction surface, and the upper surface 33c (the reflecting surface) of the base is inclined which is not parallel with the outer surface of the condensing module. Such modules may be used for being spliced on the ground away from the center of the system, and the focusing capability of the system is improved by the inclined reflecting surface.

Referring to FIG. 3 (d), presented is yet another filled-type condensing module, comprising a condensing lens L34 and a base B34. This example is similar to FIG. 3 (c), except that the upper surface 34c (the reflecting surface) of the base is a concave surface. This module can have enhanced focusing capability, making the focal length shorter. The structure in this example has a greater advantage in terms of compression resistance and durability as compared to the structure with enhanced condensing capability in FIG. 3 (a).

Referring to FIG. 3 (e), presented is a complementary type condensing module, comprising a condensing lens L35 and a base B35. The back surface 35a of the condensing lens is a plane and its tooth surface 35b is complementary in shape with and comes into tight fit with the upper surface 35c of the base, and one of the two is coated with a reflective coating to act as a reflecting surface. Since the condensing lens is in tight fit with the base, the condensing lens can be made of a rigid light-transmitting material, and the base can be made of a soft plastic material. In this case, the condensing module can withstand a high pressure without deformation and therefore is applicable to roads, such as urban roads or highways. For condensing modules of other structures, since the condensing lens needs to maintain the stability of optical parameters, it is also preferable that the condensing lens may be made by pressing a rigid transparent material; moreover, since the base mainly has the functions of supporting and pressure bearing, it is also preferable that the base is made by pressing an elastic material, such as soft rubber or plastic.

As a preferred embodiment, the reflecting surface in the condensing module may be made of a conductive material, for example, by using a metal coating, a conductive connector electrically connected with the reflecting surface is arranged at the periphery of the condensing module and the condensing modules which are spliced together are communicated in series or in parallel through the conductive connectors and are externally connected to an external power grid through a bidirectional AC inverter. In this case, the solar system may further comprise a temperature controller for initiating power supply to the condensing modules to heat the condensing modules when the ambient temperature is below a preset temperature. For simplicity, only the conductive connectors 35d and a conductive latch 35e for connecting the conductive connectors between the modules are shown in FIG. 3 (e), by respectively inserting the both ends of the latch into the conductive connectors of two adjacent modules to achieve the electrical connection between the two modules. The above-mentioned conductive connection structure can also be used for condensing modules having of other structures. It should be noted that the airtightness for the filler should be highlighted to avoid leakage when the conductive connection structure is applied to a filled-type condensing module The reverse power supply to the condensing modules by the control controller can heat a place where the condensing clad plate is laid (such as a roof or a road) in cold weather, so that the condensing clad plate has a certain anti-ice and anti-snow capability, thus being more suitable for use in cold areas.

In addition, the surface of each condensing module preferably has an anti-slipping structure when the condensing modules are applied to floor or road laying. For example, bumps or anti-slipping patterns are arranged on the surfaces of the condensing modules (usually the back surface of the condensing lens); alternatively or furthermore, an anti-slipping material such as rubber is arranged at the joints between the modules, and the height of the anti-slipping material is set to be slightly higher than the surfaces of the condensing modules.

The basic structure of the surface solar system according to the present invention can be referred to FIG. 4, comprising a condensing clad plate, a photovoltaic plate p2 and a supporting component p3. The condensing clad plate can be formed by splicing various types of condensing modules according to the needs of the actual application scenarios (e.g., compression resistance, low-temperature adaptability, etc.), including but not limited to the above-mentioned several types of condensing modules. The condenser modules can be regarded as "solar bricks" each comprising two parts, i.e., a lens and a base, and these bricks are laid in accordance with a pattern to form a large area of the condensing clad plate so as to reflect and condense sunlight reaching it. the photovoltaic plate has at least one photosurface which is capable of absorbing sunlight, and the at least one photosurface is arranged to face the condensing clad plate. The supporting component is used for supporting the photovoltaic plate above the condensing clad plate. The photovoltaic plate may be disposed on the path of focused light, preferably, basically in a condensing position of the condensing clad plate, and the condensing position is determined synthetically by the tooth surfaces and the reflecting surfaces of the condensing modules which are spliced into the condensing clad plate. In general, the condensing position is a disc-like or striped small area and the photovoltaic plate is located near the area to receive condensed sunlight with increased energy density.

As a preferred embodiment, the photovoltaic plate p2 may adopt a double-sided photovoltaic plate which is used for absorbing incident sunlight in two directions from both the front surface s5 and the back surface s6. A simple approach is to stack two single-sided photovoltaic plates back to back to obtain a double-sided photovoltaic plate. Of course, it is also possible to directly make a photovoltaic device with a double-sided light absorption capability. Due to adoption of the double-sided photovoltaic plate, on one hand, the front surface of the photovoltaic plate can absorb sunlight condensed via a convergence system, and on the other hand, the back surface thereof can also absorb directly radiated sunlight (or sunlight converged via other condensing lenses), such that with the same spatial size, the capacity of a photovoltaic plate for absorbing and utilizing solar energy is effectively improved.

Several use forms of the surface solar system according to the present invention will be described as specific examples below in connection with specific application scenarios.

### Embodiment 1

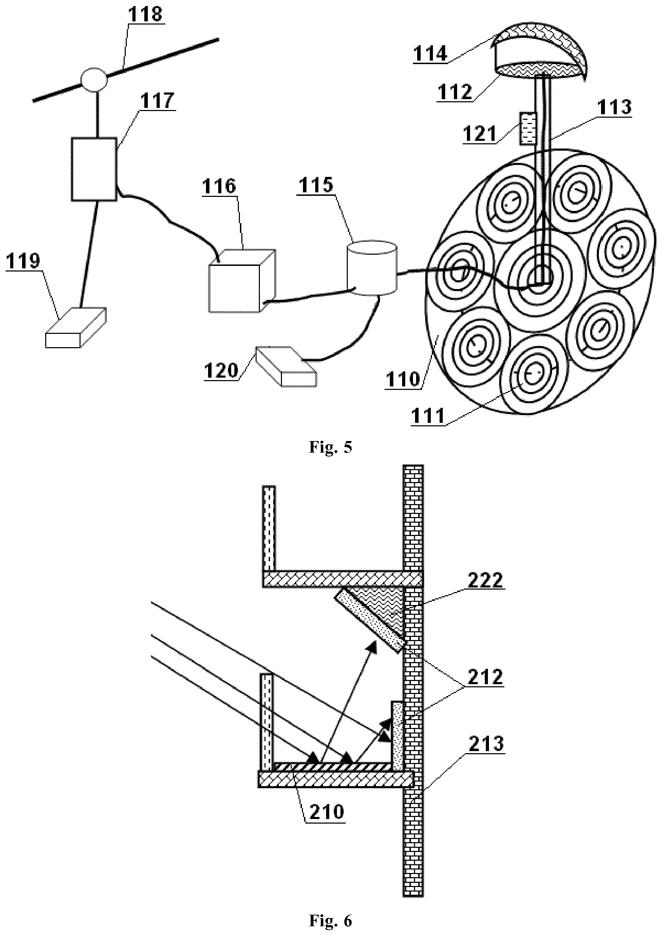

An embodiment of a surface solar system according to the present invention, referring to FIG. 5, comprises a condensing clad plate 110, a double-sided photovoltaic plate 112, and a supporting component 113.

The condensing clad plate is formed by splicing condensing modules 111 in accordance with the pattern shown in FIG. 1 (a). The condensing modules may take any of the structures shown in FIG. 3. The double-sided photovoltaic plate is supported above the central position of the condensing clad plate by the supporting component. In order to further improve the efficiency of the double-sided photovoltaic plate for utilizing the solar energy, this embodiment also comprises a top condensing lens 114 disposed above the double-sided photovoltaic plate along the incident sunlight direction. The top condensing lens is preferably a simple Fresnel lens or a composite Fresnel lens.

The condensing clad plate of the surface solar system in this embodiment can be laid on a variety of floors such as a courtyard, a roof of a building roof, the free ground on a parking lot, the ground below a utility pole or a light pole, and ground of any other free areas, so that the surface solar system in this embodiment becomes a home solar power plant, or a solar power generation system applied to a parking lot, a highway rest station, etc., to provide a large amount of clean energy. The supporting component can be arranged in combination with the condition of a construction area, for example, an existing pole or light pole may be used as the supporting component.

In order to better store and utilize the electrical energy obtained from the solar energy conversion, the present embodiment also comprises additional elements listed below, and in other embodiments, it may be possible to selectively include only one or more of them according to the needs of the application:
an energy storage 115, electrically connected to the photovoltaic panel 112 and used for storing electric energy, wherein The energy storage may be selected from a supercapacitor, a rechargeable battery and an air compressor;
an AC inverter 116, electrically connected to the energy storage (in other embodiments, it may also be electrically connected directly to the photovoltaic panel) and used for outputting and connecting its power to a networking switch cabinet 117, wherein the networking switch cabinet is connected to an external AC power grid 118 so that the electrical energy generated by the solar energy system can be incorporated into the external power grid, and the AC inverter can also be externally connected to the AC terminal board 119 to provide the AC output directly to users;
a DC voltage output device 120, electrically connected to the energy storage (in other embodiments, it may also be directly electrically connected to the photovoltaic panel) and used for outputting a DC voltage for use by users, wherein the DC voltage output from the output device may include, for example, 12V, 9V, 5V, 3V, 1.5V and so on; and
a status indicator 121 for detecting and displaying the operating parameters of the system, wherein these operating parameters may be voltage, current, power, temperature, etc., so that users can know the operating conditions of the solar energy system, and these parameters can be obtained by arranging detectors (such as a temperature probe) corresponding to the types of the required parameters.

### Embodiment 2

Another embodiment of a surface solar system according to the present invention, referring to FIG. 6, comprises a condensing clad plate 210, a photovoltaic plate 212, and a supporting component 213.

The condensing clad plate of the surface solar system in this embodiment is laid on a window sill or a balcony floor of a building (the condensing modules may adopt a variety of suitable structures, which will not be described herein again), and the walls of the building serve as the supporting component, and the photovoltaic plate is arranged at a corner and under the eaves. Sunlight reaches the balcony floor through the balustrades of the balcony or a transparent partition and then is absorbed by the photovoltaic plate after being condensed by the condensing clad plate. The system arrangement in this embodiment does not take up space and can protect the safety of the facility.

In order to adequately use the solar energy, a water heater 22 is further arranged in this embodiment. The photovoltaic plate 212, as a heat source, is wrapped by the water heater in a heat conduction manner, for example, heat exchange is implemented through close contact with the water heater by means of a thermally conductive material so that the heat energy generated by the photovoltaic plate also can be made a full use. The peripheral elements of the solar system in this embodiment can be referred to the foregoing embodiments without further explanation.

### Embodiment 3

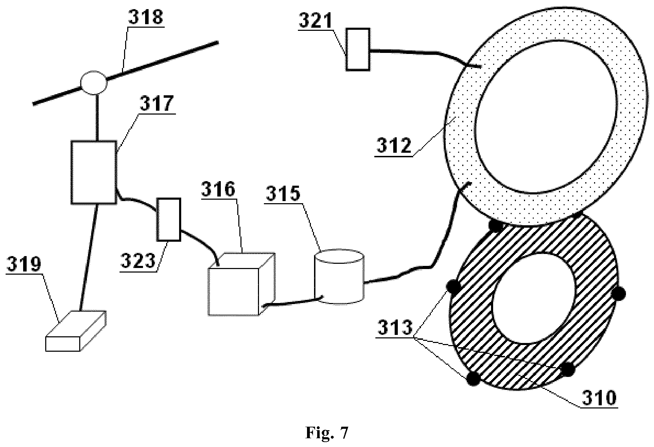

Another embodiment of a surface solar system according to the present invention, referring to FIG. 7, comprises a condensing clad plate 310, a double-sided photovoltaic plate 312, and a supporting component 313. For clarity, the double-sided photovoltaic plate and the supporting component are drafted separately in this figure; but actually, the double-sided photovoltaic plate is supported on the top of the supporting component, and the supporting component may be a building component, such as a bracket or a pillar. A top condensing lens (not shown) may be further mounted above the double-sided photovoltaic plate.

The condensing clad plate of the surface solar system in this embodiment is laid on the auditorium of a course, and the condensing modules may have structures shown in FIGS. 4(b) to (e). The pattern shown in FIG. 1 (b) or (c) may be selected because the laying area is large. The system arrangement of this embodiment is also suitable for the laying of other large-area solar systems, such as large-area solar systems laid on an emergency lane of a road, a water surface (artificial island) and the like. The overall shape of the condensing clad plate may vary with the laying sites. It is preferable to use the condensing module shown in FIG. 4(e) when it is applied to an application scenario requiring a large load.

As a preferred embodiment, when the condensing modules used have a heating function and have been electrically connected with each other, the system may comprise a temperature controller 323 such that the solar system of the present embodiment has a certain anti-snow and anti-ice capability Other peripheral components in this embodiment, for example, an energy storage 315, an AC inverter 316, a networking switch cabinet 317, an external AC power grid 318, an AC wiring board 319, a status indicator 321 and the like an refer to Embodiment 1 and will not be repeated herein.

The principles and embodiments of the present invention are illustrated above by using specific examples, and it is to be understood that the foregoing embodiments are merely used for facilitate understanding the present invention and are not to be construed as limiting the invention. For those skilled in the art, changes may be made to the specific embodiments described above in accordance with the conception of the present invention. For example, if the reflection surface in the above embodiments is arranged on a roof, the ground/a road, water, or a window, the corresponding solar energy system becomes a solar roof, a ground/road solar energy system, a solar artificial island, or a solar window.

## Claims

1. A surface solar system, comprising:
a condensing clad plate (p1), formed by splicing more than two condensing modules in accordance with a pre-set pattern, each of the condensing modules comprising a condensing lens and a base for supporting the condensing lens, the condensing lens comprising at least one tooth surface, one of adjacent surfaces of the condensing lens and the base being a reflecting surface, and the reflecting surface being provided below the tooth surface along an incident surface of sunlight;
a photovoltaic plate (p2), having at least one photosurface which is capable of absorbing sunlight, the at least one photosurface being arranged to face the condensing clad plate; and
a supporting component (p3), used for supporting the photovoltaic plate above the condensing clad plate and substantially located at a condensing position of the condensing clad plate.

2. The solar system of claim 1, wherein the pre-set pattern is selected from a concentric circle pattern, an square array pattern and a honeycomb pattern.

3. The solar system of claim 1, wherein the condensing lens is a single-side simple Fresnel lens or a single-side composite Fresnel lens, and the macroscopic curved surface of the tooth surface is shaped like a circumferentially symmetric surface or a coaxial surface.

4. The solar system of claim 1, wherein,
the condensing lens has a tooth face facing upward and a back surface coming into tight fit with an upper surface of the base and the back surface of the condensing lens is selected from a plane, a concave surface and a convex surface; or
the condensing lens has a tooth face facing downward and coming into direct contact with an upper surface of the base and the back surface of the condensing lens is selected from a plane, a concave surface and a convex surface; or
the condensing lens has a tooth face facing downward and not coming into contact with the base, a gap between the tooth face and the base is filled with a transparent filler which is selected from compressed gas and transparent liquid, and the back surface of the condensing lens is selected from a plane, a concave surface and a convex surface.

5. The solar system of claim 4, wherein the reflecting surface is arranged on the upper surface of the base and the upper surface of the base is selected from a plane, a slant, a concave surface and a convex surface.

6. The solar system of claim 1, wherein the condensing lens has a tooth face facing downward and is complementary in shape with and comes into tight fit with the upper surface of the base.

7. The solar system of any one of claims 1-6, wherein the condensing lens is made by pressing a rigid transparent material and the base is made by pressing an elastic material.

8. The solar system of any one of claims 1-7, wherein the reflecting surface is made of a conductive material, a conductive connector electrically connected with the reflecting surface is arranged at the periphery of each of the condensing modules, the condensing modules which are spliced together are communicated in series or in parallel through the conductive connectors and are externally connected to an external power grid; and
the system also comprises a temperature controller for initiating power supply to the condensing modules to heat the condensing modules when the ambient temperature is below a preset temperature.

9. The solar system of any one of claims 1-8, wherein the surface of each of the condensing module has an anti-slipping structure, the anti-slipping structure being selected from the following: bumps arranged on the surface, an anti-slipping pattern arranged on the surface, and an anti-slipping material arranged at joints of the modules, the height of the anti-slipping material being higher than the surfaces of the condensing modules.

10. The solar system of any one of claims 1-9, further comprising one or more of the following elements:
an energy storage, electrically connected to the photovoltaic plate and used for storing electric energy, the energy storage being selected from a supercapacitor, a rechargeable battery and an air compressor;
an AC inverter, electrically connected to the photovoltaic plate and used for outputting and connecting its power to a networking switch cabinet;
a DC voltage output device, electrically connected to the photovoltaic plate and used for outputting an AC voltage; and
a status indicator, used to detect and display the operating parameters of the system, the operating parameters being selected from voltage, current, power and temperature.

11. The solar system of any one of claims 1-10, wherein the photovoltaic plate is a double-sided photovoltaic plate which is used for absorbing incident sunlight in two directions from a front surface and a back surface.

12. The solar system of claim 11, further comprising a top condensing lens arranged above the double-sided photovoltaic plate along the sunlight incident direction, the top condensing lens being a simple Fresnel lens or a composite Fresnel lens.

13. The solar system of any one of claims 1-12, wherein the condensing clad plate is used for being laid on a roof, or the ground, or water, or a window.
